# EUROPEAN PATENT APPLICATION

(11) **EP 4 692 413 A1**
(43) Date of publication of application: **11.02.2026**
(21) Application number: 23937545.4
(22) Date of filing: 18.05.2023
(51) Int. Cl.: C23C 14/24

(54) **FILM-FORMING APPARATUS AND MATERIAL SUPPLY DEVICE USED FOR SAME**

(71) Applicant: Shincron Co., Ltd., Kanagawa 220-8680 (JP)
(72) Inventor: HASEGAWA, Tomokazu, Yokohama-shi, Kanagawa 220-8680 (JP); WATANABE, Ken, Yokohama-shi, Kanagawa 220-8680 (JP); KADOWAKI, Kosei, Yokohama-shi, Kanagawa 220-8680 (JP); SHOJI, Yoshinori, Yokohama-shi, Kanagawa 220-8680 (JP); AOYAMA, Takaaki, Yokohama-shi, Kanagawa 220-8680 (JP); MIYAUCHI, Mitsuhiro, Yokohama-shi, Kanagawa 220-8680 (JP); YAMAGUCHI, Takeshi, Yokohama-shi, Kanagawa 220-8680 (JP)
(74) Representative: Ter Meer Steinmeister & Partner
(86) International application number: PCT/JP2023/018609
(87) International publication number: WO 2024/236809

(57) **Abstract**

In order to supply the appropriate amount of material relative to the accommodation volume of a hearth liner, an embodiment comprises: a film-forming chamber (2) in which at least a film-forming material (M) and a film formation object (S) are provided and which can be set to a predetermined film-forming atmosphere; a hearth liner (23) that is provided inside the film-forming chamber and accommodates the film-forming material; a heat source (24) that is provided inside the film-forming chamber and heats the film-forming material accommodated in the hearth liner; a material supplier (3) that supplies the film-forming material to the hearth liner; a height gauge (4) that measures a height of a molten surface of the film-forming material accommodated in the hearth liner; and a controller (6) that calculates, based on the height of the molten surface measured by the height gauge, a mass of the film-forming material to be supplied and controls the material supplier so as to supply the calculated mass of the film-forming material to the hearth liner.

## Description

### Technical Field

The present invention relates to a film-forming apparatus and a material supply device used for the same, and more particularly to a film-forming apparatus suitable for applying a vacuum deposition method.

### Background Art

Known ones of this type of film-forming apparatuses include a film-forming apparatus comprising: a film-forming chamber that can be set to a predetermined film-forming atmosphere; a hearth liner that accommodates a film-forming material; a heat source that heats the film-forming material accommodated in the hearth liner; a material supply chamber that has a material-filled unit filled with the film-forming material to be supplied to the hearth liner and is connected to the film-forming chamber via a communicating passage with a gate valve and can be set to a predetermined pressure atmosphere; and a weight measuring device that measures the weight of the film-forming material to be supplied to the hearth liner (Patent Document 1).

### Prior Art Documents

### Patent Documents

Patent Document 1: JP6959680B

### Summary of Invention

### Problems to be solved by Invention

The above prior art allows the weight of the film-forming material supplied to the hearth liner to be measured using the weight measuring device. However, even when the weight of the film-forming material supplied to the hearth liner is known, the amount supplied may not be appropriate. For example, if the amount supplied is unduly small relative to the hearth liner's accommodation volume at the time of supply, the material may run out during film formation, causing the electron beam heat source to overheat the hearth liner, which may result in particle generation. In addition, if the amount supplied is unduly large, the material may overflow from the hearth liner. If the material overflows from the hearth liner, it will be discarded, resulting in a problem of high material costs.

The problem to be solved by the present invention is to provide a film-forming apparatus and a material supply device used therein that are able to supply the appropriate amount of material relative to the accommodation volume of a hearth liner.

### Means for solving Problems

The present invention solves the above problem through measuring the height of molten surface of a film-forming material accommodated in a hearth liner, calculating, based on the measured height of the molten surface, the mass of the film-forming material to be supplied, and controlling a material supplier so as to supply the calculated mass of the film-forming material to the hearth liner.

### Effect of Invention

According to the present invention, the height of the molten surface of the film-forming material accommodated in the hearth liner is measured to determine the volume deficit of the film-forming material relative to the volume of the hearth liner, and the mass deficit of the film-forming material is calculated from the volume deficit and the specific gravity of the film-forming material. By controlling the material supplier so that the determined mass deficit of film-forming material is supplied to the hearth liner, it is possible to supply the appropriate amount of material relative to the accommodation volume of the hearth liner.

### Brief Description of Drawings

[FIG. 1] FIG. 1 is a block diagram including a vertical cross-sectional view of the main portion illustrating a film-forming apparatus according to an embodiment of the present invention.
[FIG. 2] FIG. 2 is a plan view of FIG. 1.
[FIG. 3A] FIG. 3A is a schematic diagram illustrating a first example of the material supplier of FIG. 1.
[FIG. 3B] FIG. 3B is a schematic diagram illustrating a second example of the material supplier of FIG. 1.
[FIG. 3C] FIG. 3C is a schematic diagram illustrating a third example of the material supplier of FIG. 1.
[FIG. 4A] FIG. 4A is a front view illustrating a dispersion member provided in the nozzle of FIG. 1.
[FIG. 4B] FIG. 4B is a view taken along arrow IVB of FIG. 4A.
[FIG. 4C] FIG. 4C is a view taken along arrow IVC of FIG. 4A.
[FIG. 5] FIG. 5 is a vertical cross-sectional view illustrating the height gauge of FIG. 1.
[FIG. 6] FIG. 6 is a flowchart illustrating main processing executed by the controller of FIG. 1.
[FIG. 7] FIG. 7 is a flowchart illustrating a subroutine of step S4 of FIG. 6.

### Mode(s) for carrying out Invention

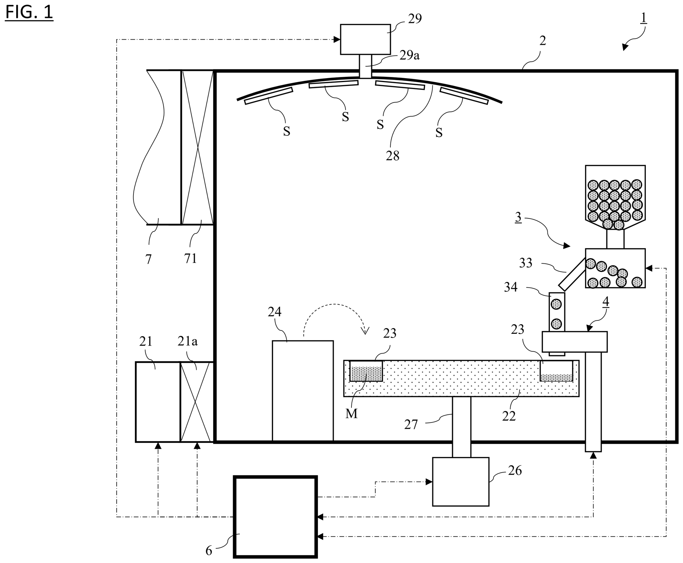

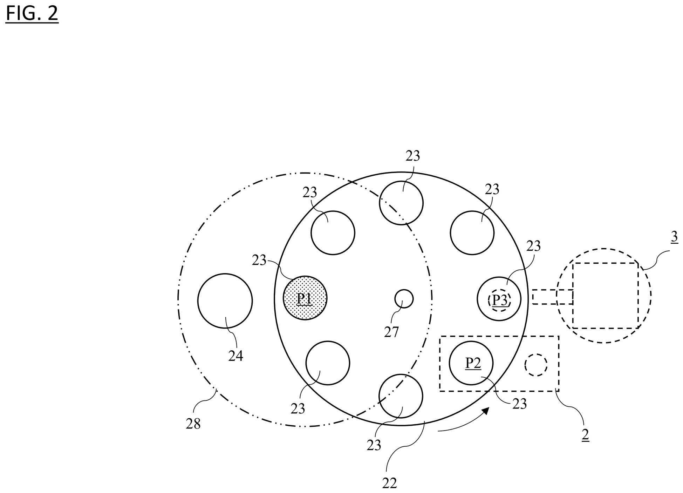

Hereinafter, one or more embodiments of the present invention will be described with reference to the drawings. FIG. 1 is a block diagram including a vertical cross-sectional view of the main portion illustrating a film-forming apparatus according to an embodiment of the present invention, and FIG. 2 is a plan view of the same. The film-forming apparatus of the present invention can typically be embodied as a vacuum vapor deposition apparatus, and the film-forming apparatus 1 using a vacuum vapor deposition method will therefore be described below as an embodiment of the present invention. It is, however, not intended that the film-forming apparatus of the present invention is limited only to a vacuum vapor deposition apparatus using a vacuum vapor deposition method, and the film-forming apparatus of the present invention represents those in a broad sense including film-forming apparatuses other than the vacuum vapor deposition apparatus.

### «Overall Configuration of Film-Forming Apparatus 1»

The film-forming apparatus 1 of the present embodiment includes a film-forming chamber 2 in which at least a film-forming material M and a film formation object S are provided and which can be set to a predetermined film-forming atmosphere. The film-forming chamber 2 is provided with an evacuation device 21 via a gate valve 21a. By opening the gate valve 21a to evacuate the gas inside the film-forming chamber 2, the inside of the film-forming chamber 2 can be set, for example, to a vacuum atmosphere suitable for a vapor deposition process. As the pressure inside the film-forming chamber 2 decreases, the mean free path of the film-forming material M increases, and the evaporation temperature of the film-forming material decreases, thus promoting the vapor deposition process. The evacuation device 21 and the gate valve 21a are controlled by command signals from a controller 6.

The film-forming chamber 2 is provided with a film formation object holder 28 that supports film formation objects S such as semiconductor wafers, glass substrates, or plastic substrates. The film formation object holder 28 is suspended from the ceiling of the film-forming chamber 2. Although not particularly limited, the film formation object holder 28 of the present embodiment is composed of a plate-like member that has a concaved spherical surface so that distances between the film formation objects S and a hearth liner 23 in which the film-forming material M evaporates are as uniform as possible. Also although not particularly limited, the film formation object holder 28 of the present embodiment is configured to be rotatable by a holder drive unit 29 composed of a motor and the like, and this configuration also contributes to an approximately uniform thickness of the films formed on respective film formation objects S. The holder drive unit 29 is controlled by a command signal from the controller 6.

The film-forming chamber 2 is provided with a load lock chamber (preliminary vacuum chamber) 7, which is connected to the film-forming chamber 2 via a gate valve 71. The inside of the load lock chamber 7 can also be set to the same vacuum atmosphere as the film-forming chamber 2 by an evacuation device (not illustrated) provided in the load lock chamber 7. The load lock chamber 7 is provided with a door (not illustrated), and access to the outside of the film-forming apparatus 1, which is in the ambient pressure atmosphere, can be performed through the door.

The film formation object holder 28 is detachably attached to a rotation shaft 29a or the like of the holder drive unit 29. When performing the film formation process, a robot (not illustrated) or the like is used to grip the film formation object holder 28 loaded with a plurality of film formation objects S before film formation, and the film formation object holder 28 is carried into the film-forming chamber 2 from the load lock chamber 7 and attached to the rotation shaft 29a of the holder drive unit 29. After the film formation process is completed, the load lock chamber 7 is set to the same vacuum atmosphere as the film-forming chamber 2, and then the gate valve 71 is opened. In this state, a robot (not illustrated) or the like is used to grip the film formation object holder 28 loaded with the film formation objects S after film formation, and the film formation object holder 28 is carried out from the film-forming chamber 2 to the load lock chamber 7. Thus, by providing the load lock chamber 7, it is possible to carry the film formation objects S into or out of the film-forming chamber 2 while maintaining the vacuum atmosphere of the film-forming chamber 2. The film-forming apparatus of the present invention can also be used as a batch-type film-forming apparatus, in which the film-forming chamber 2 is returned to the atmospheric pressure and the film formation object holder 28 holding a plurality of film formation objects S is replaced each time the film formation process is completed.

The film-forming chamber 2 is provided with a hearth holder 22 that is supported on the floor surface inside the film-forming chamber 2 so as to be rotatable around a shaft 27. The hearth holder 22 is capable of stepping rotation at a predetermined rotation angle around the shaft 27 by a hearth holder drive unit 26 and a rotary encoder (not illustrated). The hearth holder drive unit 26 is composed of a motor and the like.

Although not particularly limited, the hearth holder 22 supports eight hearth liners 23 concentrically, as illustrated in FIGS. 1 and 2. Also although not particularly limited, the eight hearth liners 23 are provided at equal angles in the circumferential direction with respect to the shaft 27.

Each hearth liner 23 is a so-called crucible of melting furnace into which the film-forming material M is fed to be heated and melted, and is also called a hearth block or simply a hearth. Although not particularly limited, the hearth liner 23 of the present embodiment can be composed of copper, molybdenum, or tungsten. When the surface of the film-forming material M accommodated in the hearth liner 23 is irradiated with an electron beam from an electron gun that is a heat source 24 and electrons are introduced, an electric current flows through the hearth liner 23, causing the hearth liner 23 to glow red and reach a temperature at which the accommodated film-forming material M can be evaporated. The hearth holder 22 is made of copper, although not particularly limited.

The heat source 24, which is provided inside the film-forming chamber 2, heats and evaporates the film-forming material M accommodated in the hearth liner 23. For the heat source 24, electron beam heating using an electron gun as well as resistance heating, high frequency induction heating, and laser beam heating can be used. The heat source 24 of the film-forming apparatus 1 of the embodiment illustrated in FIG. 1 adopts electron beam heating using an electron gun, and one hearth liner 23 located at the closest position (indicated by hatching in FIG. 2; also referred to as an evaporation position P1, hereinafter) is irradiated with the electron beam.

The film-forming material M of the present embodiment is fed into the hearth liner 23 in granular form, which is melted within the hearth liner 23 by the heat source 24. The eight hearth liners 23 may all be fed with the same type of film-forming material M, or different types of film-forming material M may also be fed. Alternatively, fewer than eight types of film-forming materials M may be distributed among the eight hearth liners 23.

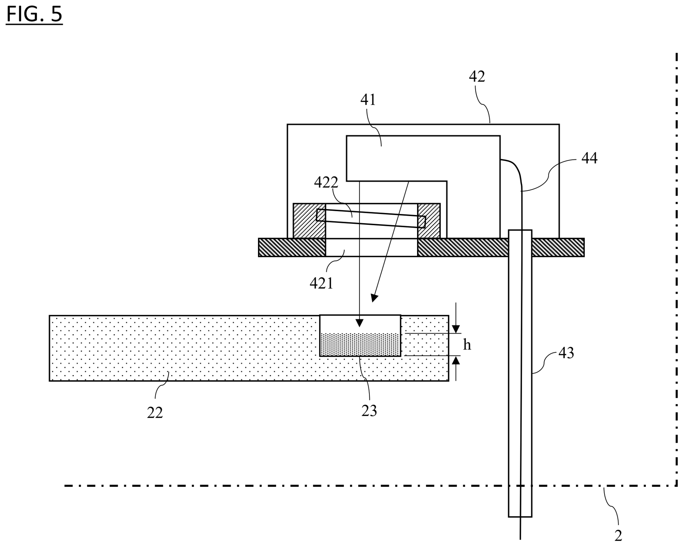

The film-forming apparatus 1 of the present embodiment includes, within the film-forming chamber 2, a material supplier 3 that supplies the film-forming material M to the hearth liner 23 and a height gauge 4 that measures a height h (see FIG. 5) of the molten surface of the film-forming material M accommodated in the hearth liner 23. The film-forming apparatus 1 also includes a controller that calculates, based on the height h of the molten surface measured by the height gauge 4, the mass of the film-forming material M to be supplied and controls the material supplier 3 so as to supply the calculated mass of the film-forming material M to the hearth liner 23. In the present embodiment, the controller 6 that controls the film-forming apparatus 1 and the controller 6 that controls the material supplier 3 are configured as a single controller, but they may also be configured as separate controllers that send and receive signals between them.

### «Configuration of Material Supplier 3»

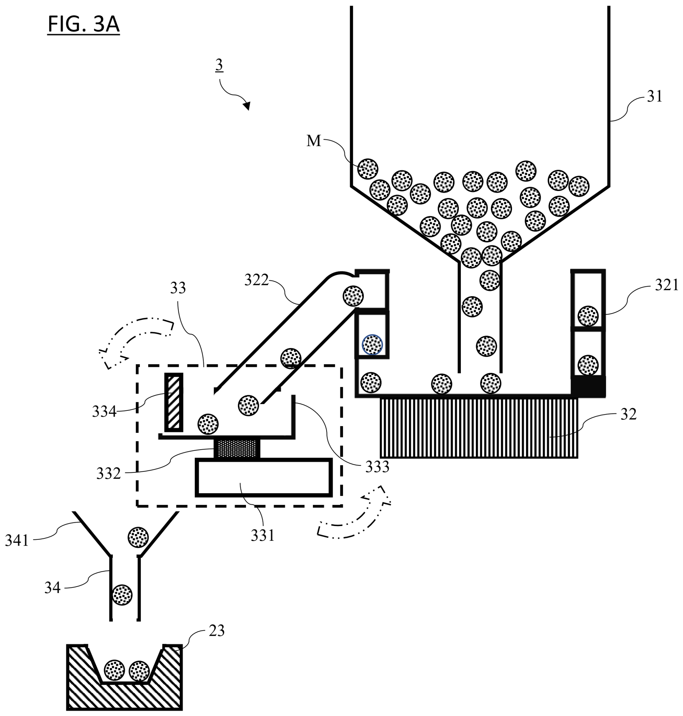

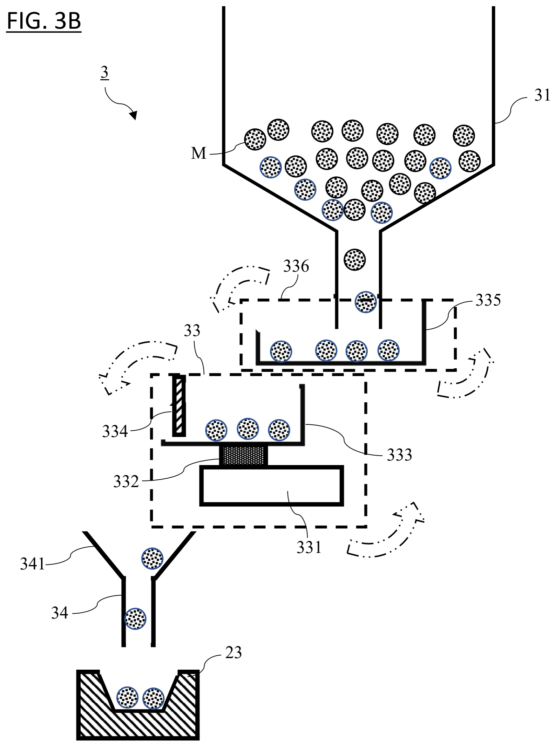

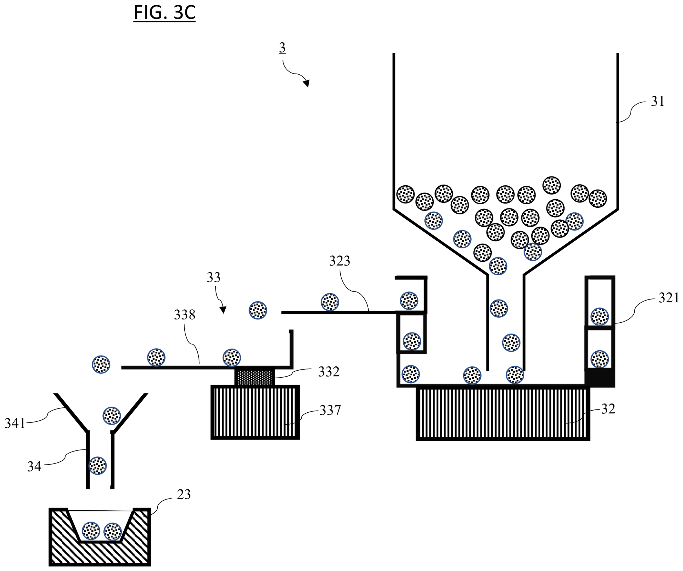

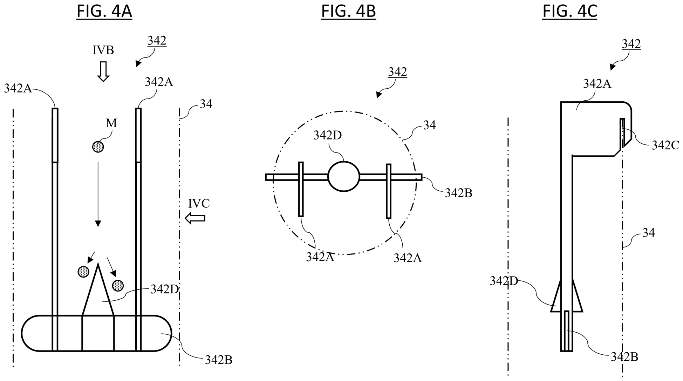

FIG. 3A illustrates a first example of the material supplier 3 of the present embodiment, FIG. 3B is a diagram illustrating a second example of the material supplier 3 of the present embodiment, and FIG. 3C is a diagram illustrating a third example of the material supplier 3 of the present embodiment. FIG. 4A is a front view illustrating a dispersion member provided in a nozzle, FIG. 4B is a view taken along arrow IVB of FIG. 4A, and FIG. 4C is a view taken along arrow IVC of FIG. 4A.

In the plan view illustrated in FIG. 2, the material supplier 3 of the present embodiment is installed to supply the film-forming material M to one hearth liner 23 located at a position P3 (also referred to as a material supply position P3, hereinafter), which is different from the evaporation position P1. When the hearth holder 22 rotates counterclockwise as illustrated by the arrow in FIG. 2, the height gauge 4 of the present embodiment is installed to measure the height h of the molten surface of the film-forming material M for one hearth liner 23 located at a position P2 (also referred to as a measurement position P2, hereinafter), which is different from the evaporation position P1 and is located upstream of the material supply position P3 in the direction of rotation.

Regarding the positional relationship between the measurement position P2 of the molten surface for the height gauge 4 and the material supply position P3 for the material supplier 3, when the measurement position P2 is located upstream of the material supply position P3 in the rotation direction of the hearth holder 22, it is advantageous in reducing the rotation distance of the hearth holder 22 from the measurement of the height h of the molten surface until the supply of the film-forming material M. However, this is not intended to be a limitation, and the measurement position P2 and the material supply position P3 can be set anywhere other than the evaporation position P1.

As illustrated in FIG. 3A, the material supplier 3 according to the first example of the present embodiment includes a hopper 31, a bowl feeder 32, a measuring and feeding mechanism 33, and a nozzle 34. The hopper 31 is a tank that stores the film-forming material M in granular form. A shutter (not illustrated) is provided at the bottom opening portion, and opening this shutter allows the granular film-forming material M to fall under its own weight into the bowl feeder 32. During the preparation step prior to the start of the film formation process, the film-forming chamber 2 is kept in the atmospheric environment, so a sufficient amount of the granular film-forming material M is fed into the hopper 31 during this preparation step.

The bowl feeder 32 is a device that vibrates the granular film-forming material M fed into a bowl 321 from the hopper 31, thereby conveying the granular film-forming material M toward a chute 322 while moving it along a spiral guide path (not illustrated) formed inside the bowl 321. The bowl feeder 32 of the present embodiment includes a vibrator such as a piezoelectric element. While the vibrator is turned on, the granular film-forming material M is conveyed toward the chute, and when the vibrator is turned off, the conveyance of the granular film-forming material M stops. The vibrator is turned on/off by the controller 6.

The measuring and supply mechanism 33 of the present embodiment includes a load cell 332 provided on a base 331, a receiving tray 333 that temporarily holds the granular film-forming material M supplied from the chute 322, and a partition plate 334 fixed to the film-forming apparatus 1 side to prevent the granular film-forming material M from spilling from the receiving tray 333. The measuring and supply mechanism 33 of the present embodiment has a function of measuring the mass of the granular film-forming material M supplied from the bowl feeder 32 using the load cell 332 while receiving the granular film-forming material M in the receiving tray 333, and outputting a signal to stop the supply from the bowl feeder 32 when a predetermined mass is reached.

The load cell 332 serves as a mass sensor that detects the mass of the receiving tray 333 and the granular film-forming material M supplied to the receiving tray 333 and outputs this mass as an electrical signal to the controller 6. The load cell 332 and the receiving tray 333 are rotated in the direction indicated by the two-dot chain arrows by a dump mechanism (not illustrated), allowing the granular film-forming material M supplied to the receiving tray 333 to fall into an opening wall 341 of the nozzle 34.

The receiving tray 333 is shaped like a "dustpan" having a bottom surface and three continuous side surfaces, one of which is open, so when the granular film-forming material M is fed at the original position illustrated in FIG. 3A, the film-forming material M may spill from the open side surface. A partition plate 334 is therefore fixed to the film-forming apparatus 1 side to cover the open side surface and prevent the film-forming material M from spilling when the receiving tray 333 is in its original position. When the load cell 332 and the receiving tray 333 rotate in the direction indicated by the dashed-dotted arrows, the film-forming material M falls toward the nozzle 34 through the gap between the fixed partition plate 334 and the receiving tray 333.

The nozzle 34 is fixed to the film-forming apparatus 1 side so as to be positioned directly above the material supply position P3. The nozzle 34 of the present embodiment has an opening wall 341 at the upper end of its cylindrical body, which has an opening area larger than that of the interior of the cylindrical body. This prevents the granular film-forming material M, which falls from the receiving tray 333, from spilling around the upper end of the nozzle 34.

The nozzle 34 of the present embodiment is provided with a dispersion member 342. FIG. 4A is a front view illustrating the dispersion member provided in the nozzle, FIG. 4B is a view taken along arrow IVB of FIG. 4A, and FFIG. 4C is a view taken along arrow IVC of FIG. 4A. The dispersion member 342 of the present embodiment includes a pair of side plates 342A and 342A, a back plate 342B connected to the side plates, notches 342C formed in the pair of side plates 342A and 342A for fixing to the nozzle 34, and a dispersion body 342D provided at the lower ends of the pair of side plates 342A and 342A and having an upwardly facing conical surface.

As illustrated in the view taken along arrow IVB of FIG. 4B (plan view), the dispersion member 342 of the present embodiment is attached to the nozzle 34 so that the dispersion body 342D is located approximately at the center of the nozzle 34. The granular film-forming material M falling from the receiving tray 333 passes through the cylindrical main body of the nozzle 34 and falls from the opening portion at the lower end onto the hearth liner 23. At this time, it is necessary to disperse the granular film-forming material M as evenly as possible throughout the opening portion of the hearth liner 23. By providing the dispersion member 342 of the present embodiment in the nozzle 34, as illustrated in the front view of FIG. 3A, the granular film-forming material M falling from above strikes the conical surface of the dispersion body 342D and is dispersed 360 degrees around it, and the granular film-forming material M can therefore be supplied evenly to the opening portion of the hearth liner 23.

FIG. 3B is a diagram illustrating a second example of the material supplier 3 of the present embodiment, in which a receiving tray 335 and a dump mechanism 336 are provided in place of the bowl feeder 32 of the material supplier 3 of the first example illustrated in FIG. 3A. That is, as illustrated in FIG. 3B, the material supplier 3 according to the second example of the present embodiment includes the hopper 31, the receiving tray 335, the dump mechanism 336 that rotates the receiving tray 335, the measuring and supply mechanism 33, and the nozzle 34. Like the above-described first example, the hopper 31 of this example is a tank that stores the film-forming material M in granular form. A shutter (not illustrated) is provided at the bottom opening portion, and opening this shutter allows the granular film-forming material M to fall under its own weight into the bowl feeder 32. During the preparation step prior to the start of the film formation process, the film-forming chamber 2 is kept in the atmospheric environment, so a sufficient amount of the granular film-forming material M is fed into the hopper 31 during this preparation step.

The receiving tray 335 of this example receives the granular film-forming material M fed into the hopper 31 and, at a predetermined timing, is rotated by the dump mechanism 336 in the direction indicated by the dash-dotted arrows, allowing the granular film-forming material M supplied to the receiving tray 335 to fall into a lower receiving tray 333.

The measuring and supply mechanism 33 of this example includes a load cell 332 provided on a base 331, a receiving tray 333 that temporarily holds the granular film-forming material M supplied from the chute 322, and a partition plate 334 fixed to the film-forming apparatus 1 side to prevent the granular film-forming material M from spilling from the receiving tray 333. The measuring and supply mechanism 33 of this example has a function of measuring the mass of the granular film-forming material M supplied from the bowl feeder 32 using the load cell 332 while receiving the granular film-forming material M in the receiving tray 333, and outputting a signal to stop the supply from the bowl feeder 32 when a predetermined mass is reached. The measuring and supply mechanism 33 of this example is the same as that of the above-described first example, so the same components are denoted by the same reference numerals, and the description thereof is borrowed herein.

The nozzle 34 of this example is fixed to the film-forming apparatus 1 side so as to be positioned directly above the material supply position P3. The nozzle 34 of this example has an opening wall 341 at the upper end of its cylindrical body, which has an opening area larger than that of the interior of the cylindrical body. This prevents the granular film-forming material M, which falls from the receiving tray 333, from spilling around the upper end of the nozzle 34. The nozzle 34 of this example is also provided with the above-described dispersion member 342. The nozzle 34 of this example is the same as that of the above-described first example, so the same components are denoted by the same reference numerals, and the description thereof is borrowed herein.

FIG. 3C is a diagram illustrating a third example of the material supplier 3 of the present embodiment, in which a bowl feeder nozzle 323 is provided in place of the chute 322 of the material supplier 3 of the first example illustrated in FIG. 3A and a linear feeder 337 and a linear feeder nozzle 338 are provided in place of the receiving tray 333 and its dump mechanism. That is, as illustrated in FIG. 3C, the material supplier 3 according to the third example of the present embodiment includes the hopper 31, the bowl feeder 32, the measuring and supply mechanism 33, and the nozzle 34. Like the above-described first example, the hopper 31 of this example is a tank that stores the film-forming material M in granular form. A shutter (not illustrated) is provided at the bottom opening portion, and opening this shutter allows the granular film-forming material M to fall under its own weight into the bowl feeder 32. During the preparation step prior to the start of the film formation process, the film-forming chamber 2 is kept in the atmospheric environment, so a sufficient amount of the granular film-forming material M is fed into the hopper 31 during this preparation step.

The bowl feeder 32 is a device that vibrates the granular film-forming material M fed into a bowl 321 from the hopper 31, thereby conveying the granular film-forming material M toward the bowl feeder nozzle 323 while moving it along a spiral guide path (not illustrated) formed inside the bowl 321. The bowl feeder 32 of the present embodiment includes a vibrator such as a piezoelectric element. While the vibrator is turned on, the granular film-forming material M is conveyed toward the bowl feeder nozzle 323, and when the vibrator is turned off, the conveyance of the granular film-forming material M stops. The vibrator is turned on/off by the controller 6.

The measuring and supply mechanism 33 of this example includes a load cell 332 provided on the linear feeder 337 and a linear feeder nozzle 338 that temporarily holds the granular film-forming material M supplied from the bowl feeder nozzle 323. The measuring and supply mechanism 33 of this example has a function of measuring the mass of the granular film-forming material M supplied from the bowl feeder 32 using the load cell 332 while receiving the granular film-forming material M in the linear feeder nozzle 338, and outputting a signal to stop the supply from the bowl feeder 32 when a predetermined mass is reached.

The load cell 332 serves as a mass sensor that detects the mass of the linear feeder nozzle 338 and the granular film-forming material M supplied to the linear feeder nozzle 338 and outputs this mass as an electrical signal to the controller 6. The linear feeder 337 is operated to vibrate the linear feeder nozzle 338, allowing the granular film-forming material M supplied to the linear feeder nozzle 338 to fall into an opening wall 341 of the nozzle 34.

### «Configuration of Height Gauge 4»

FIG. 5 is a vertical cross-sectional view illustrating the height gauge 4 of the present embodiment. As illustrated in FIG. 5, the height gauge 4 of the present embodiment includes a laser displacement sensor 41 with a built-in camera, and a casing 42 that airtightly encloses the laser displacement sensor 41 together with a wiring conduit 43. The bottom surface of the casing 42 is formed with an opening portion 421 that allows laser light to pass through and ensures the camera's field of view, and a glass plate 422 is provided to maintain the airtight condition. Wiring 44 of the laser displacement sensor 41 is led out of the film-forming chamber 2 via the wiring conduit 43; therefore, even when the inside of the film-forming chamber 2 is put into a vacuum state, the laser displacement sensor 41 and its wiring 44 can be used in the atmospheric pressure environment.

The laser displacement sensor 41 with a built-in camera measures the height h of the molten surface of the hearth liner 23 by irradiating the opening portion of the hearth liner 23 at the measurement position P2 with laser light and receiving the reflected light. The height h of the molten surface as referred to herein means the distance from the bottom surface of the hearth liner 23 to the molten surface. That is, because the position of the bottom surface of the hearth liner 23 and the height position of the laser displacement sensor 41 at the measurement position P2 are known, the height h of the molten surface can be calculated from the measurement value of the laser displacement sensor 41.

Examples of the height gauge of the present invention include, in addition to those using the laser displacement sensor 41 illustrated in FIG. 5, those that measure the height h of the molten surface using other optical means, those that measure the height h of the molten surface from image data acquired using a camera or the like, and contact-type displacement sensors that measure the height h of the molten surface by contacting a contact maker with the molten surface.

### «Configuration and Operational Flow of Controller 6»

The controller 6 calculates, based on the height h of the molten surface measured by the height gauge 4, the mass of the film-forming material to be supplied and controls the material supplier 3 to supply the calculated mass of the film-forming material M to the hearth liner 23. That is, the height h of the molten surface of the hearth liner 23 at the measurement position P2 is calculated using the laser displacement sensor 41, and therefore the volume of the film-forming material M remaining in the hearth liner 23 can be calculated. For example, when the hearth liner 23 is a uniform cylindrical container, the height h of the molten surface is proportional to the volume, and this relationship can be used to calculate the volume of the remaining film-forming material M from the height h of the molten surface. Alternatively, when the hearth liner 23 is not a uniformly shaped container, the relationship of the volume with respect to the height h of the molten surface is preliminarily determined, and this relationship may be used to calculate the volume of the remaining film-forming material M from the height h of the molten surface. Then, when the amount of the remaining film-forming material M becomes small, the mass deficit of the film-forming material M may be determined from the volume deficit of the material and the specific gravity of the material, and the material supplier 3 is controlled to supply the weight deficit of the granular film-forming material M to the hearth liner 23.

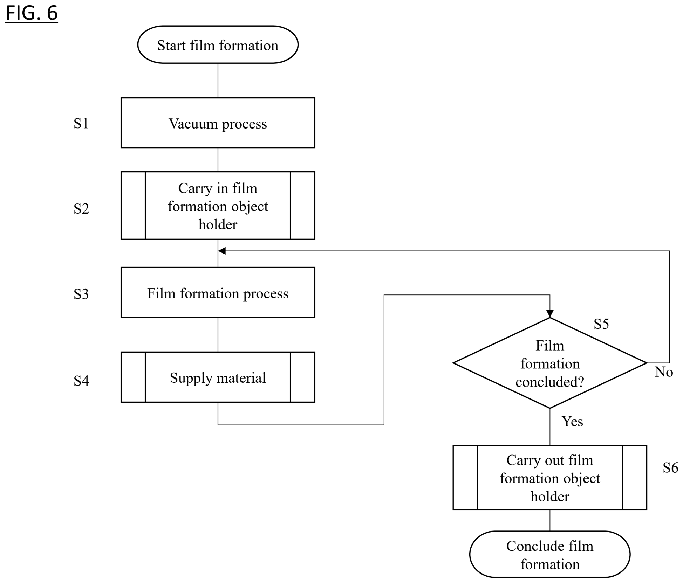

An overview of the film formation process using the film-forming apparatus 1 of the present embodiment will now be described. FIG. 6 is a flowchart illustrating the main processing executed by the controller 6 of the film-forming apparatus 1 of the present embodiment. First, when starting the film formation process, in step S1, the gate valve 21a of the film-forming chamber 2 is opened and the evacuation device 21 is used to evacuate the interior of the film-forming chamber 2, thereby creating a predetermined vacuum atmosphere inside the film-forming chamber 2.

Then, in step S2, the film formation object holder 28 loaded with a plurality of film formation objects S before film formation is grasped using a robot (not illustrated) or similar device and carried into the load lock chamber 7, and the interior of the load lock chamber 7 is then created with the same vacuum atmosphere as the film-forming chamber 2. Then, the gate valve 71 is opened, the film formation object holder 28 loaded with a plurality of film formation objects S before film formation is carried from the load lock chamber 7 to the film-forming chamber 2 using a robot or similar device and attached to the rotation shaft 29a of the holder drive unit 29, and the gate valve 71 of the load lock chamber 7 is then closed. The order of steps S1 and S2 at the start of film formation may be reversed.

Next, in step S3, the hearth holder drive unit 26 is driven to move the hearth liner 23 accommodating the film-forming material M to be deposited to the deposition position P1. Then, while the holder drive unit 29 is driven to rotate the film formation object holder 28 at a predetermined constant speed, the heat source 24 is driven to heat the hearth liner 23 at the evaporation position P1 and evaporate the film-forming material M. This allows the evaporated film-forming material M to be deposited on the film formation object S to form a film.

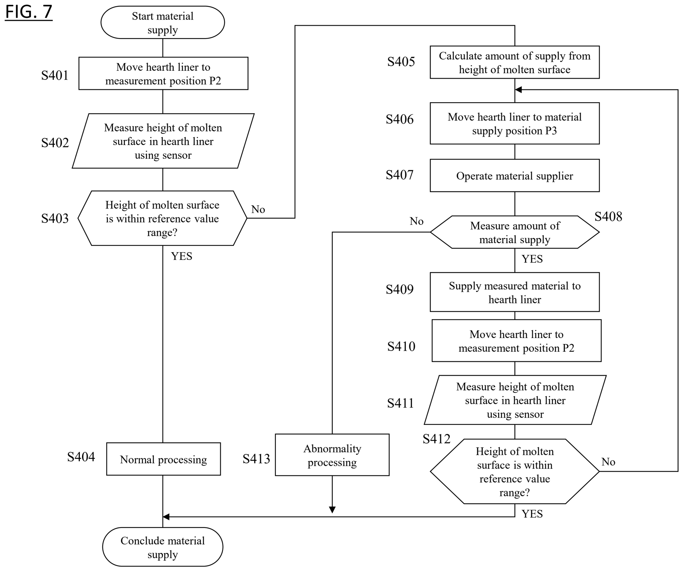

In the subsequent step S4, a determination is made as to whether or not a supply (replenishment) of the film-forming material M is required. When continuous film formation processes are performed while maintaining the vacuum state of the film-forming chamber 2 or when the type of the film-forming material M is changed, a supply of the film-forming material M is required, so after performing the material supply described with reference to FIG. 7, the process proceeds to step S5.

FIG. 7 is a flowchart illustrating the material supply subroutine of step S4 of FIG. 6. First, in step S401, the hearth holder drive unit 26 is driven to move the hearth liner 23 to be fed to the measurement position P2. In the subsequent step S402, the laser displacement sensor 41 irradiates the molten surface of the hearth liner 23 with laser light and receives the reflected light, thereby inputting the measurement value corresponding to the height h of the molten surface from the height gauge 4.

In the film-forming apparatus 1 of the present embodiment, an appropriate height h of the molten surface in each hearth liner 23 is preliminarily set, for example, a reference value with a lower limit is set. In step S403, a determination is made as to whether or not the measured value of the height h of the molten surface input from the height gauge 4 is within a reference value range, which is preliminarily set (whether or not it is greater than or equal to the lower limit). When the measured value of the height h of the molten surface is within the reference value range, the process proceeds to step S404, in which normal processing is determined and no material feeding is required, terminating the material feeding process.

In contrast, when the measured value of the height h of the molten surface input from the height gauge 4 is not within the reference value range, this means that there is no film-forming material M remaining in the hearth liner 23, or only a small amount, so the process proceeds to step S405, in which the amount of the film-forming material M to be supplied is calculated from the measured value of the height h of the molten surface input from the height gauge 4. For example, the volume of the film-forming material M to be supplied can be determined from the measured value of the height h of the molten surface input from the height gauge 4, and the mass of the film-forming material M to be supplied can be calculated from the volume of the film-forming material M to be supplied and the specific gravity of the film-forming material M.

In the subsequent step S406, the hearth holder drive unit 26 is driven to move the hearth liner 23 to be supplied with material to the material supply position P3, and in step S407, the material supplier 3 is operated. In the next step S408, the weight of the granular film-forming material M is measured using the load cell 332 while being supplied by the material supplier 3. When the weight (material supply amount) calculated in step S405 is reached, the process proceeds to step S409, in which the film-forming material M, having been weighed and confirmed to be a predetermined material supply amount, is supplied to the hearth liner 23. At the same time, the material supplier 3 is stopped. In step S408, if for some reason the measurement value of the load cell 332 does not reach the material supply amount calculated in step S405, the process proceeds to step S413, in which abnormality processing is performed and the material supply process is then concluded.

In step S410, the hearth holder drive unit 26 is driven to move the hearth liner 23 supplied with material in step S409 back to the measurement position P2. In the subsequent step S411, the laser displacement sensor 41 irradiates the molten surface of the hearth liner 23 with laser light and receives the reflected light, thereby inputting the measurement value corresponding to the height h of the molten surface from the height gauge 4. Then, in step S412, a determination is made as to whether or not the measured value of the height h of the molten surface input from the height gauge 4 is within a reference value range, which is preliminarily set (whether or not it is greater than or equal to the lower limit). When the measured value of the height h of the molten surface is within the reference value range, the material supply process is concluded. In contrast, when the measured value of the height h of the molten surface input from the height gauge 4 is not within the preset reference value range in step S412, the process returns to step S406, and the processing of steps S406 to S411 is executed again.

Referring again to FIG. 6, in step S5, a determination is made as to whether the film formation process is concluded. When it continues, the process returns to step S3, in which the film formation process continues until vapor-deposited films of a predetermined thickness are formed on the plurality of film formation objects S attached to the film formation object holder 28. When a determination is made in step S5 that the film formation process is concluded, the process proceeds to step S6, in which the load lock chamber 7 is set to the same vacuum atmosphere as the film-forming chamber 2, and then the gate valve 71 is opened. In this state, a robot or the like is used to grip the film formation object holder 28 loaded with the plurality of film formation objects S after completion of the film formation, and the film formation object holder 28 is carried out from the film-forming chamber 2 to the load lock chamber 7. After that, the gate valve 71 is closed, then the load lock chamber 7 is returned to the atmospheric pressure atmosphere, and the film formation object holder 28 loaded with the plurality of film formation objects S after the film formation is carried out to the outside through a door (not illustrated). Thus, the film formation process is concluded.

### Description of Reference Numerals

- 1: Film-forming apparatus
- 2: Film-forming chamber
21 Evacuation device
21a Gate valve
22 Hearth holder
23 Hearth liner
24 Heat source
26 Hearth holder drive unit
27 Shaft
28 Film formation object holder
29 Holder drive unit
- 3: Material supplier
31 Hopper
32 Bowl feeder
321 Bowl
322 Chute
323 Bowl feeder nozzle
33 Measuring and feeding mechanism
331 Base
332 Load cell
333 Receiving tray
334 Partition plate
335 Receiving Tray
336 Dump mechanism
337 Linear feeder
338 Linear feeder nozzle
34 Nozzle
341 Opening wall
342 Dispersing member
342A Side plate
342B Back plate
342C Notch
342D Dispersion body
- 4: Height gauge
41 Laser displacement sensor
42 Casing
421 Opening portion
422 Glass plate
43 Wiring conduit
44 Wiring
- 6: Controller
- 7: Load lock chamber
71 Gate valve
- M: Film-forming material
- S: Film formation object
- P1: Evaporation position
- P2: Measurement position
- P3: Material supply position

## Claims

1. A film-forming apparatus comprising:
a film-forming chamber in which at least a film-forming material and a film formation object are provided and which can be set to a predetermined film-forming atmosphere;
a hearth liner that is provided inside the film-forming chamber and accommodates the film-forming material;
a heat source that is provided inside the film-forming chamber and heats the film-forming material accommodated in the hearth liner;
a material supplier that supplies the film-forming material to the hearth liner;
a height gauge that measures a height of a molten surface of the film-forming material accommodated in the hearth liner; and
a controller that calculates, based on the height of the molten surface measured by the height gauge, a mass of the film-forming material to be supplied and controls the material supplier so as to supply the calculated mass of the film-forming material to the hearth liner.

2. The film-forming apparatus according to claim 1, wherein the material supplier and/or the height gauge are provided inside the film-forming chamber.

3. The film-forming apparatus according to claim 1 or 2, comprising
a hearth holder that is provided rotatably inside the film-forming chamber and concentrically supports a plurality of the hearth liners,
wherein the film-forming apparatus is configured to:
for the hearth liner located at an evaporation position among the plurality of hearth liners, use the heat source to heat the film-forming material;
for the hearth liner located at a measurement position different from the evaporation position among the plurality of hearth liners, use the height gauge to measure the height of the molten surface of the film-forming material; and
for the hearth liner located at a material supply position different from the evaporation position and the measurement position among the plurality of hearth liners, use the material supplier to supply the film-forming material.

4. The film-forming apparatus according to claim 1 or 2, wherein
the material supplier includes a hopper that stores the film-forming material, a conveying mechanism that conveys the film-forming material stored in the hopper to the hearth liner, and a load cell that measures the mass of the film-forming material during its conveyance, and
the controller determines whether or not the mass measured by the load cell reaches the calculated mass, and supplies the film-forming material to the hearth liner when the mass measured by the load cell reaches the calculated mass.

5. The film-forming apparatus according to claim 1 or 2, wherein
the material supplier includes a bowl feeder that applies vibrations to the film-forming material in granular form to convey it, and a load cell that sequentially measures the mass of the film-forming material conveyed from the bowl feeder, and
the controller controls the bowl feeder to apply vibrations to the film-forming material in granular form until the mass measured by the load cell reaches the calculated mass.

6. The film-forming apparatus according to claim 1 or 2, wherein
the material supplier includes a hopper that stores the film-forming material, a conveying mechanism that conveys the film-forming material stored in the hopper to the hearth liner, and a nozzle that guides the film-forming material conveyed by the conveying mechanism to the hearth liner, and
the nozzle includes a cylindrical nozzle main body that extends vertically and a dispersing member that is provided inside the nozzle main body and disperses the film-forming material in granular form naturally fallen from above the nozzle main body.

7. A material supply device for use in a film-forming apparatus, comprising:
a hopper that stores a film-forming material;
a conveying mechanism that conveys the film-forming material stored in the hopper to a hearth liner of the film-forming apparatus;
a load cell that measures a mass of the film-forming material during its conveyance; and
a controller,
wherein the controller determines whether or not the mass measured by the load cell reaches a predetermined mass, and supplies the film-forming material to the hearth liner when the mass measured by the load cell reaches the predetermined mass.

8. The material supply device according to claim 7, comprising:
a bowl feeder that applies vibrations to the film-forming material in granular form to convey it; and
a load cell that sequentially measures the mass of the film-forming material conveyed from the bowl feeder,
wherein the controller controls the bowl feeder to apply vibrations to the film-forming material in granular form until the mass measured by the load cell reaches the predetermined mass.

9. The material supply device according to claim 6 or 7, comprising:
a hopper that stores the film-forming material in granular form;
a conveying mechanism that conveys the film-forming material stored in the hopper to the hearth liner; and
a nozzle that guides the film-forming material conveyed by the conveying mechanism to the hearth liner,
wherein the nozzle comprises:
a cylindrical nozzle main body that extends vertically; and
a dispersing member that is provided inside the nozzle main body and disperses the film-forming material in granular form naturally fallen from above the nozzle main body.
